Europäisches Patentamt

European Patent Office

Office européen des brevets

(19)

(11) Veröffentlichungsnummer: **0 166 418**
**A2**

## (12) EUROPÄISCHE PATENTANMELDUNG

(21) Anmeldenummer: 85107825.3

(22) Anmeldetag: 24.06.85

(51) Int. Cl.⁴: **H 01 R 23/66, H 01 R 23/68**

(30) Priorität: 29.06.84 DE 3423920

(43) Veröffentlichungstag der Anmeldung: 02.01.86
Patentblatt 86/1

(84) Benannte Vertragsstaaten: BE FR GB LU NL SE

(71) Anmelder: SCHOELLER & CO. Elektrotechnische Fabrik
GmbH & Co., Mörfelder
Landstrasse 115-119 Postfach 70 11 40, D-6000 Frankfurt
am Main (DE)

(72) Erfinder: Fischer, Alexander, Am Krämersrain 17,
D-6380 Bad Homburg v.d.H. (DE)
Erfinder: Khouzam, Sabry, Im Hirtengarten 39,
D-6464 Lützelhausen (DE)
Erfinder: Löffler, Edmund, Liegnitzer Strasse 13,
D-6000 Frankfurt am Main 70 (DE)

(54) Flexible Leiterbahnabgangslasche für bedruckte Schaltungsfolien.

(57) Um bei beidseitig bedruckten Folien einseitig kontaktierende Stecker verwenden zu können, werden Zungen in der Leiterbahnabgangslasche vorgesehen, die die Leiterbahnenden der Folienunterseite tragen und umbiegbar sind. Durch das Umbiegen der Zungen kommt das unten liegende Leiterbahnende nach oben, so dass sämtliche Leiterbahnenden auf der Folienoberseite liegen und in einen einseitig kontaktierenden Stecker eingeschoben werden können.

EP 0 166 418 A2

Die Erfindung betrifft eine flexible Leiterbahnabgangslasche für bedruckte Schaltungsfolien zum Aufschieben einseitig kontaktierender Stecker.

Es ist bekannt, Folien für Schaltungszwecke beidseitig mit Leiterbahnen zu bedrucken, so daß sowohl die Oberseite als auch die Unterseite der Folie Leiterbahnen aufweist. Die Leiterbahnen enden auf einer Lasche, auf die ein Stecker aufgeschoben wird. Der Stecker wird in ein Kupplungsstück eingesteckt, das mit den Zuleitungen verbunden ist. Bei bedruckten Folien für Folienschalter (Tastenfelder) ist beispielsweise die Oberseite der Folie mit Kontaktflächen und den zugehörigen Leiterbahnen versehen, während die Unterseite ein Abschirmgitter trägt. Für beidseitig bedruckte Folien wurden bisher Stecker verwendet, die sowohl mit den Leiterbahnenden auf der Oberseite der Folie als auch mit den Leiterbahnenden auf der Unterseite der Folie Kontakt geben. Stecker für einseitig bedruckte Folien können also in diesem Fall nicht benutzt werden, da bei diesen Steckern keine Kontakte für die Leiterbahnenden auf der Unterseite der Folien vorhanden sind.

Aufgabe der Erfindung ist es daher, die Leiterbahnabgangslasche einer beidseitig bedruckten Folie so auszubilden, daß auf die Lasche auch Stecker, die nur für einseitig bedruckte Folien bestimmt sind, aufgesetzt werden können. Dies wird gemäß der Erfindung auf vorteilhafte Weise dadurch erreicht, daß sich bei beidseitig bedruckten Folien Zungen in der Leiterbahnabgangslasche befinden, die Leiterbahnenden tragen und zum Einschieben in einseitig kontaktierende Stecker umbiegbar sind.

Die umbiegbaren Zungen gemäß der Erfindung haben den Vorteil, daß auch bei beidseitig bedruckten Schaltungsfolien die einfacheren und billigeren einseitig kontaktierenden Stecker verwendet werden können. Dadurch wird die Lagerhaltung für die Stecker vereinfacht, weil für einseitig und beidseitig bedruckte Schaltungsfolien nur eine Steckerart erforderlich ist.

Schoeller & Co. Elektrotechnische Fabrik GmbH & Co          Mörfelder Landstraße 115-119  6000 Frankfurt M 70

Eine vorteilhafte Weiterbildung der Erfindung wird darin gesehen, daß sich auf der Oberseite der Folie die Schaltung für einen Folienschalter und auf der Unterseite der Folie ein Abschirmnetz befindet, dessen Leiterbahnabgang auf eine umbiegbare Zunge in der Leiterbahnabgangslasche aufgedruckt ist. Die Zunge kann mittig in der Leiterbahnabgangslasche angeordnet und in diese eingestanzt sein. Zur Freilegung der Zungen können U-förmige Schlitze vorgesehen sein, um das Umbiegen zu erleichtern. Die Leiterbahnabgangslasche und die Zungen können einander entgegengerichtet sein.

Anhand der in der Zeichnung dargestellten Ausführungsform soll die Erfindung jetzt näher erläutert werden. Es zeigt:

Fig. 1 bis 5     den Stand der Technik, von dem die Erfindung ausgeht und

Fig. 6 bis 13   ein Ausführungsbeispiel der Erfindung.

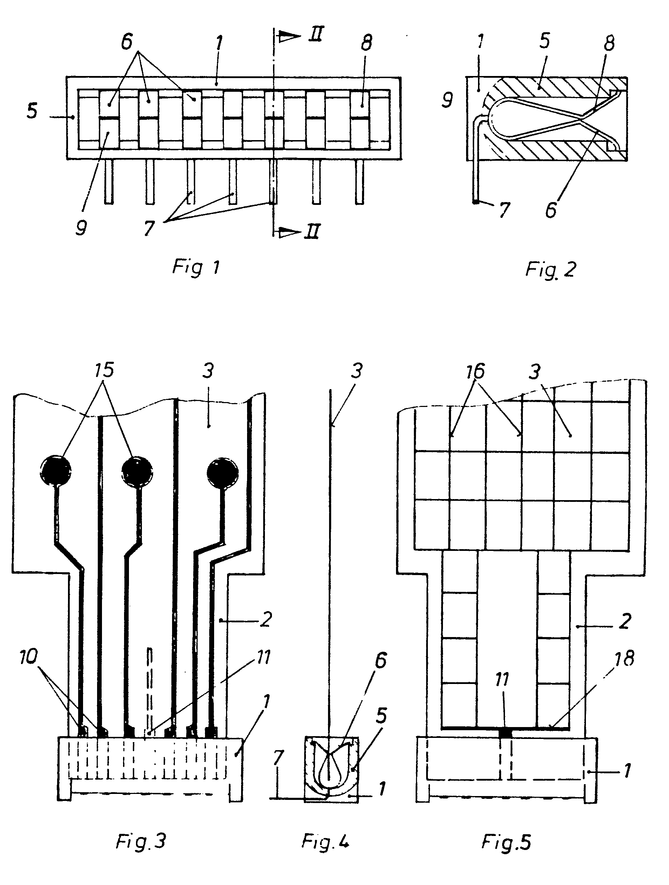

Ein bekannter Stecker 1 für beidseitig bedruckte Schaltungsfolien ist in Fig. 1 in Vorderansicht und in Fig. 2 im Schnitt entlang der Linie 1 - I nach Fig. 1 dargestellt. Die Fig. 3 bis 5 zeigen die in den Stecker 1 eingeschobene Lasche 2 einer beidseitig bedruckten Folie 3. Der Stecker 1 besteht aus dem Gehäuse 5 und in dieses eingesetzte Doppelkontaktfedern 6 mit Steckerstiften 7. Zwischen die beiden federnden Schenkel 8 und 9 der Doppelkontaktfeder 6 wird die Lasche 2 eingeschoben, so daß entweder der obere Schenkel 8 mit einem Leiterbahnende 10 auf der Oberseite oder der Schenkel 9 mit einem Leiterbahnende 11 auf der Unterseite der Folie 3 in Berührung kommt. Nach Fig. 3 weist die Oberseite der Folie 3 Leiterbahnen 14 und Kontaktflächen 15 für einen Folienschalter (Tastenfeld) und die Unterseite nach Fig. 5 ein Abschirmnetz 16 mit dem zugehörigen Leiterbahnende 11 und 18 auf.

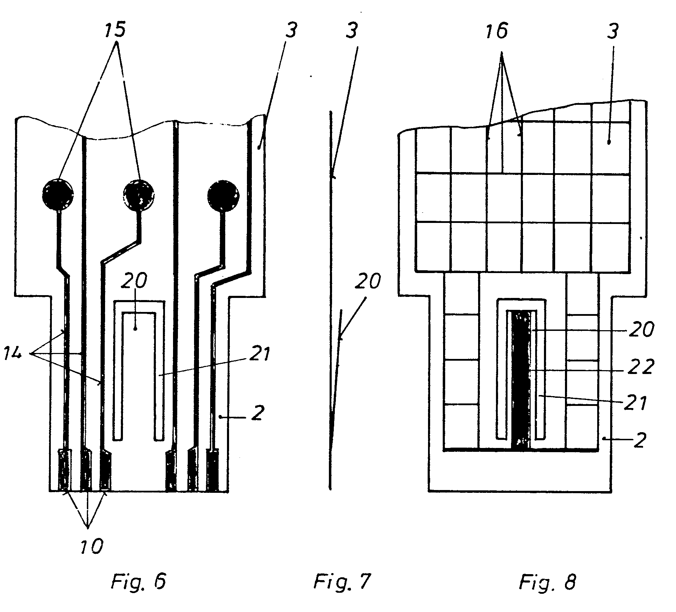

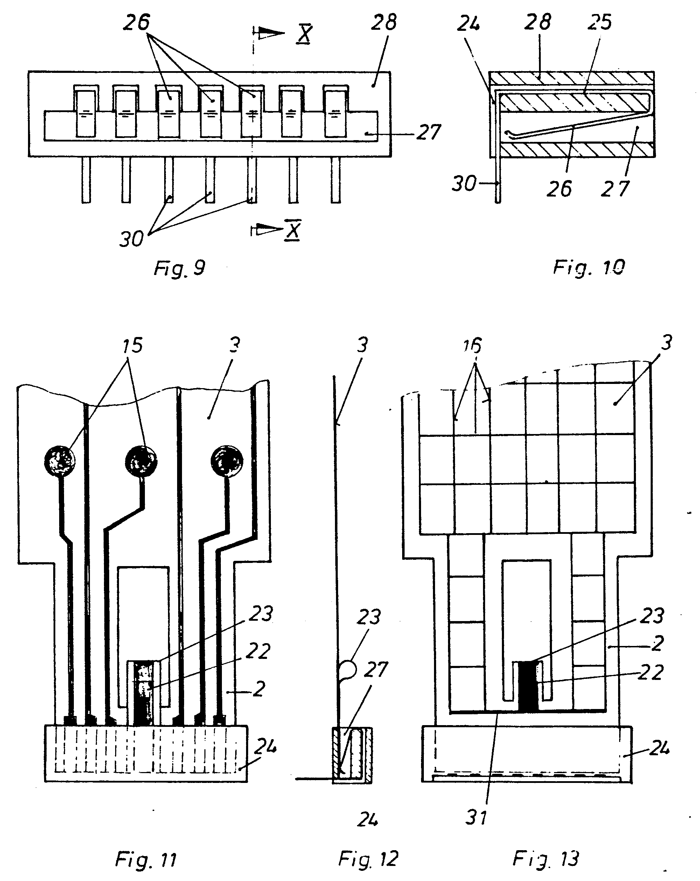

Die erfindungsgemäße Ausführungsform der Leiterbahnabgangslasche 2 nach Fig. 6 bis 8 weist eine Zunge 20 auf, die durch einen
ausgestanzten U-förmigen Schlitz 21 freigelegt und die der Lasche 2
entgegengerichtet ist. Die Unterseite der Zunge 20 weist das Leiterbahnende 22 des Abschirmnetzes 16 auf. Wird die Zunge 20 zu einer
Schlaufe 23 umgelegt, dann kommt das Leiterbahnende 22 nach oben,
und es kann ein einseitig kontaktierender Stecker 24 verwendet
werden, wie dies die Fig. 9 bis 13 erkennen lassen. Fig. 9 zeigt den
einseitig kontaktierenden Stecker 24 in Vorderansicht und Fig. 10 im
Schnitt entlang der Linie X - X nach Fig. 9. Der Stecker 24 besitzt
eine mehrfach abgewinkelte Kontaktfeder 25, deren federnder Schenkel
26 in einen Schlitz 27 des Steckergehäuses 28 hineinragt und Kontakt
mit den Leiterbahnenden 10 auf der Leiterbahnabgangslasche 2 gibt.
Die Kontaktfedern 25 laufen in Steckerstifte 30 aus, die in ein
nicht dargestelltes Kupplungsstück mit den Anschlußleitungen einsteckbar sind. Wie aus Fig. 11 bis 13 hervorgeht, wird auch das
Leiterbahnende 22 auf der zu einer Schlaufe 23 umgelegten Zunge 20
von dem federnden Schenkel 26′einer in der Mitte des einseitig
kontaktierenden Steckers 24 befindlichen Kontaktfeder 25 berührt.
Das Leiterbahnende 22 steht über eine quer verlaufende Leiterbahn 31
mit dem auf der Unterseite der bedruckten Folie 3 aufgebrachten
Abschirmnetz 16 in Verbindung.

Es versteht sich, daß die Erfindung keineswegs auf das in der
Zeichnung dargestellte und oben beschriebene Ausführungsbeispiel
beschränkt ist. Vielmehr gibt es mannigfaltige Abwandlungsmöglichkeiten in der Gestaltung der Leiterbahnabgangslasche und der Ausbildung und Anordnung der Zungen, ohne daß dabei der Rahmen
der Erfindung verlassen wird.

--.--

Flexible Leiterbahnabgangslasche für bedruckte Schaltungsfolien
================================================================

Patentansprüche:

1. Flexible Leiterbahnabgangslasche für bedruckte Schaltungsfolien zum Aufschieben einseitig kontaktierender Stecker, dadurch gekennzeichnet, daß sich bei beidseitig bedruckten Folien (3) Zungen (20) in der Leiterbahnabgangslasche (2) befinden, die die Leiterbahnenden (22) tragen und zum Einschieben in einseitig kontaktierende Stecker (24) umbiegbar sind.

2. Leiterbahnabgangslasche nach Anspruch 1, dadurch gekennzeichnet, daß sich auf der Oberseite der Folie (3) die Schaltung (14, 15) für einen Folienschalter und auf der Unterseite der Folie (3) ein Abschirmnetz (16) befindet, dessen Leiterbahnabgang (22) auf eine umbiegbare Zunge (20) in der Leiterbahnabgangslasche (2) aufgedruckt ist.

3. Leiterbahnabgangslasche nach Anspruch 2, dadurch gekennzeichnet, daß die Zunge (20) mittig in der Leiterbahnabgangslasche (2) angeordnet ist.

4. Leiterbahnabgangslasche nach einem der Ansprüche 1 bis 3, dadurch gekennzeichnet, daß die Zungen (20) in die Leiterbahnabgangslasche (2) eingestanzt sind.

5. Leiterbahnabgangslasche nach Anspruch 4, dadurch gekennzeichnet, daß zur Erleichterung des Umbiegens U-förmige Schlitze (21) zur Freilegung der Zungen (20) vorgesehen sind.

6. Leiterbahnabgangslasche nach einem der Ansprüche 1 bis 5, dadurch gekennzeichnet, daß die Leiterbahnabgangslasche (2) und die Zungen (20) einander entgegengerichtet sind.

- . -

Fig 1

Fig. 2

Fig.3

Fig.4

Fig.5

Fig. 6          Fig. 7          Fig. 8

Fig. 9

Fig. 10

Fig. 11

Fig. 12

Fig. 13